(19) Europäisches Patentamt
European Patent Office
Office européen des brevets

(11) **EP 3 506 483 B1**

(12) **EUROPEAN PATENT SPECIFICATION**

(45) Date of publication and mention
of the grant of the patent:
**09.03.2022 Bulletin 2022/10**

(21) Application number: **16914197.5**

(22) Date of filing: **25.08.2016**

(51) International Patent Classification (IPC):
*H02M 7/5395* $^{(2006.01)}$     *H02M 1/00* $^{(2006.01)}$
*H02P 27/06* $^{(2006.01)}$     *H02P 27/08* $^{(2006.01)}$
*G01R 23/02* $^{(2006.01)}$     *G01R 23/15* $^{(2006.01)}$

(52) Cooperative Patent Classification (CPC):
**H02M 7/5395; H02P 23/14;** G01R 23/15;
H02M 1/0012; H02M 1/0025; H02P 27/08

(86) International application number:
**PCT/JP2016/074744**

(87) International publication number:
**WO 2018/037523 (01.03.2018 Gazette 2018/09)**

(54) **POWER CONVERSION DEVICE**

STROMWANDLUNGSVORRICHTUNG

DISPOSITIF DE CONVERSION DE COURANT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**03.07.2019 Bulletin 2019/27**

(73) Proprietor: **Hitachi Industrial Equipment Systems
Co., Ltd.**
**Tokyo 101-0022 (JP)**

(72) Inventor: **ARAO, Yusuke**
**Tokyo 101-0022 (JP)**

(74) Representative: **MERH-IP Matias Erny Reichl
Hoffmann**
**Patentanwälte PartG mbB**
**Paul-Heyse-Strasse 29**
**80336 München (DE)**

(56) References cited:
**EP-A2- 0 802 622        JP-A- S62 196 098
JP-A- 2004 289 959        JP-A- 2011 101 445
JP-A- 2014 212 631        US-A1- 2011 218 751
US-A1- 2013 054 666**

**Description**

TECHNICAL FIELD

The present invention relates to a power conversion device.

BACKGROUND ART

As a background technology in this technical field, there is disclosed JP 2011-101445 A (Patent Document 1). Patent Document 1 discloses that "The number of revolutions and a phase are detected from a voltage detected from a line voltage detection circuit, and a phase lag due to control in a controller and a phase lag due to the circuit are corrected and restarting is performed. Furthermore, attention is paid to a difference between an induced voltage estimated from the detected number of revolutions and an actually detected induced voltage, and in a case where a difference of a certain value or more occurs in the difference, there is provided means for determining that a detected frequency is erroneously detected or stopped, and changing the restarting."

CITATION LIST

PATENT DOCUMENT

Patent Document 1: JP 2011-101445 A
Patent Document 2: EP 0 802 622 A2
Patent Document 3: JP 2014 212631 A
Patent Document 4: US 2011/218751 A1
Patent Document 5: US 2013/054666 A1

SUMMARY OF THE INVENTION

PROBLEMS TO BE SOLVED BY THE INVENTION

Patent Document 1 discloses that, since an output of the voltage detection circuit is input to an AD converter possessed by an MCU, and a voltage pulse output of a pulse conversion circuit is input to an input port possessed by the MCU, the MCU recognizes the number of revolutions of the induced voltage, and the phase and magnitude thereof, and the MCU calculates an output frequency and an output voltage based on the current number of revolutions and voltage phase of a synchronous motor detected from the voltage detection circuit and the pulse conversion circuit.
Patent Document 2 describes a driving apparatus for a brushless motor comprising rotor position detecting means, an address counter, a waveform data memory, phase output command creating means, and an inverter circuit.
Patent Document 3 describes an inverter device that includes: a power conversion section; a system frequency measurement section; an individual operation detection section; a frequency feedback section; a reactive power step injection section; and a current control processing section for performing current control on the power conversion section.
Patent Document 4 describes a method for continuously predicting a frequency of an input line power waveform of alternating current having a maximum value, a minimum value, and a reference value located between the maximum and minimum values.
Patent Document 5 describes a method for predicting a value for a length of a future time interval in which a physical variable changes is described, in which at least one measured value for the length of a past time interval and an instantaneously measured value for a length of an instantaneous time interval are taken into account, m values for lengths of past time intervals being added. A first value precedes the instantaneously measured value by k-1, and an mth value precedes the instantaneously measured value by k-m. The m added values are divided by a value for a length of a past time interval which precedes the instantaneously measured value by k. A ratio of the mentioned values is formed. For determining the value to be predicted, an average error is initially added to the instantaneously measured value, forming a sum. The formed ratio is subsequently applied to this sum.

In some cases, by using a method as illustrated in Patent Document 1, for example, a general-purpose power conversion device acquires a frequency from an AC current, an AC voltage, or a pulse train output which is output by an externally connected system separate from the power conversion device, or from a feedback signal and the like of a motor driven by a different power conversion device, and uses the frequency as a command frequency for driving the motor. In that case, the general-purpose power conversion device has a problem that, for example, in a case where the signal indicated above has 0.1 Hz in a period and is input, the signal is not updatable for 10s and a period of updating the frequency is extended. Also, for example, in a case where, when two power conversion devices control the motor, a rotation signal of the motor driven by one power conversion device serving as a master is used for controlling an output frequency of the other power conversion device serving as a slave, there is a problem that it is difficult to achieve synchronization because a pulse will not arrive for 10s or more even though an output is cut off when the master operates at 0.09 Hz or less.

SOLUTIONS TO PROBLEMS

The subject-matter of the appended claims solves this problem. For example, claim 1 defines a power conversion device having an AC converting unit that performs power conversion and a calculating unit that controls the AC converting unit, in which the calculating unit includes a period converting unit that converts an input signal into a period signal, a period calculating unit that calculates an acquired frequency f from the period signal, and a control unit that outputs an output command according to the acquired frequency, and in a case where the period signal is not acquirable during a period longer than the period of the period signal acquired from the period converting unit at a preceding time, the period calculating unit is configured to calculate a time period during which the period signal is not acquirable, and to output the time period as the acquired frequency, wherein at a time point, when a period from the rising of a pulse at the preceding time to the falling of the pulse is set to Tpre and a predetermined time Tover has elapsed after the elapse of Tpre, the period calculating unit (112) is configured to calculate the frequency f by the following equation and predict a pulse train input command of a low frequency before acquiring pulse edges: $f = 1/(2 \times (Tpre + Tover))$, wherein in a case where a current period input is longer than its previous period input, the acquired frequency is updated such that the acquired frequency decreases before an edge of the current period input arrives, so that it is possible to make a timing of updating the acquired frequency early.

EFFECTS OF THE INVENTION

According to the present invention, it is possible to provide a power conversion device capable of capturing update information at a timing earlier than a timing of the period determination even though a captured period becomes long.

BRIEF DESCRIPTION OF THE DRAWINGS

Fig. 1 is an example of a configuration diagram of a power conversion device in Embodiment 1.
Fig. 2 is a flowchart illustrating procedures of calculation performed by a period calculating unit in Embodiment 1.
Fig. 3 is a diagram illustrating a relationship between a period input and an acquired frequency determined by the period calculating unit in Embodiment 1.
Fig. 4 is a diagram for describing the processing of predicting an acquired frequency before acquiring pulse edges thereof, in the case of a period input of a low frequency in Embodiment 1.
Fig. 5 is an example of a configuration diagram of a power conversion device in Embodiment 2.
Fig. 6 is a diagram illustrating a relationship between an acquired frequency and a command range in Embodiment 2.

MODE FOR CARRYING OUT THE INVENTION

Hereinafter, embodiments will be described with reference to the drawings.

Embodiment 1

In the present embodiment, an example of operation in which an external apparatus outputs a pulse train output, and a power conversion device connected to the external apparatus captures the pulse train output as the command frequency and performs output operation on a motor will be described.

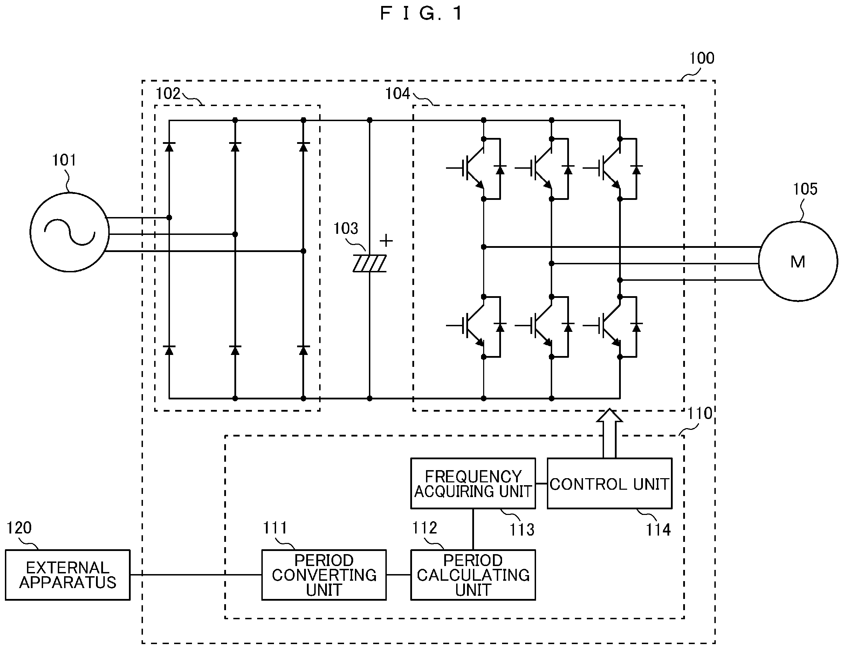

Fig. 1 is an example of a configuration diagram of an AC motor 105 and a power conversion device 100 connected to an external apparatus 120 in the present embodiment.

The power conversion device 100 in the present embodiment is configured with a calculating unit 110, an AC converting unit 104, a smoothing capacitor 103, and a DC converting unit 102 connected to a three-phase AC power supply 101. The calculating unit 110 includes a period converting unit 111, a period calculating unit 112, a frequency acquiring unit 113, and a control unit 114.

The three-phase AC power supply 101 is, for example, a three-phase AC voltage supplied from a power company or an AC voltage supplied from a generator, and outputs the AC voltage to the DC converting unit 102.

The DC converting unit 102 is configured with, for example, a DC conversion circuit configured with a diode, or a DC conversion circuit using an IGBT and a flywheel diode, converts the AC voltage input from the three-phase AC power supply 101 into a DC voltage, and outputs the DC voltage to the smoothing capacitor 103. Fig. 1 illustrates a DC converting unit configured with a diode as one example.

The smoothing capacitor 103 smoothes the DC voltage input from the DC converting unit 102 and outputs the smoothed DC voltage to the AC converting unit 104. For example, in a case where the output of the generator is a DC voltage, the DC voltage directly from the generator may be input to the smoothing capacitor 103, without passing through the DC converting unit 102.

The AC converting unit 104 is configured with, for example, an AC conversion circuit using an IGBT and a flywheel diode, uses the DC voltage of the smoothing capacitor 103 and an output command of the control unit 114 as an input, converts the DC voltage into an AC voltage, and supplies the converted AC voltage of a desired frequency to the AC motor 105. Also, in the case of being configured with an AC conversion circuit that performs AC-AC conversion without passing through the smoothing capacitor 103, the AC converting unit 104 may convert an AC voltage into another AC voltage and may output the other AC voltage to the AC motor 105.

The period converting unit 111 uses the pulse train output, an AC current, or an AC voltage, which is output by an external apparatus 120, as an input, converts an input signal into a period signal, and outputs the period signal to the period calculating unit 112.

The period calculating unit 112 calculates a frequency from the period signal converted by the period converting unit 111 and outputs the frequency to the frequency acquiring unit 113. In a case where the period signal is not changed during a longer time than a period of the signal at a preceding time, the period calculating unit 112 determines that a period of the period signal has been extended, and calculates the frequency.

The frequency acquiring unit 113 uses the frequency output from the period calculating unit 112 as an input, and acquires the frequency as a command value, and then outputs the frequency to the control unit 114 as an acquired frequency.

The control unit 114 issues a PWM output command to the AC converting unit 104, according to an output command calculated from a command issued to drive the AC motor 105.

The external apparatus 120 is for periodically issuing a command to the power conversion device 100 by, for example, a PLC, an encoder for capturing the operation of an external system, a pulse train output apparatus, an AC voltage source, and the like, and performs input operation on the period converting unit 111.

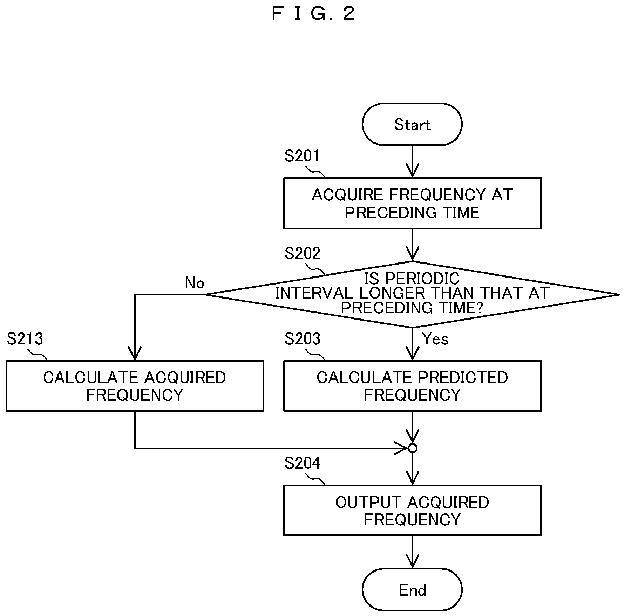

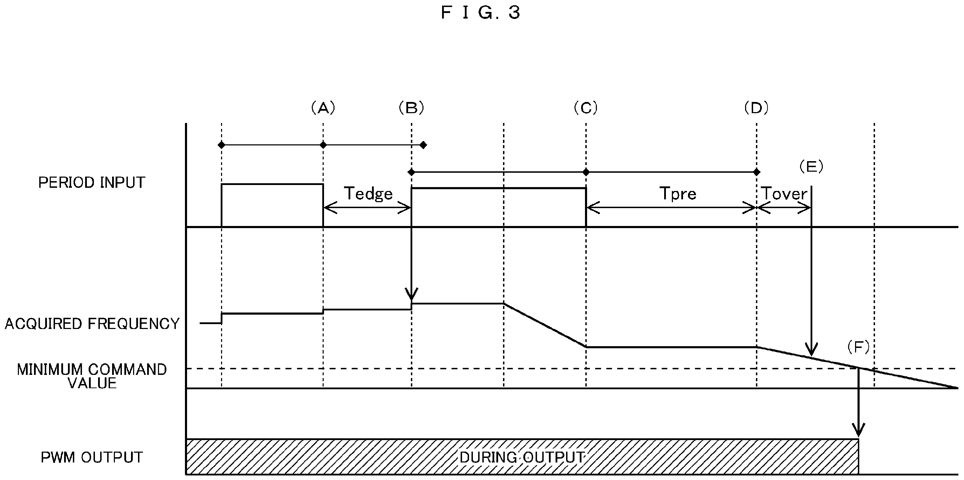

Fig. 2 is a flowchart illustrating procedures of determination in the calculation performed by the period calculating unit 112. Also, Fig. 3 is an example of the outputs of a period input and an acquired frequency calculated by the period calculating unit 112.

In Fig. 2, the period calculating unit 112 holds or acquires a frequency calculated at a preceding time (S201). Then, the period calculating unit 112 determines whether a periodic interval is longer than that at the preceding time (S202). In a case where a period acquired at the present time is shorter than a period acquired at the preceding time, the period calculating unit 112 calculates a frequency as an acquired frequency at a stage where the period has been determined (S213). That is, the acquired frequency is calculated for each of a rising edge or a falling edge of a pulse, and for example, an acquired period is determined when a period input is changed at a time point (B) after the period is determined at a time point (A) in Fig. 3.

Specifically, a period from the rising of a pulse to the falling of the pulse, or from the falling of a pulse to the rising of the pulse is set to one period Tedge, and in a case where a pulse train input having a period T exists, the period calculating unit 112 calculates a frequency f using the following equation (1).

$$f = 1/(2 \times Tedge) \ ...(1)$$

The period T may be defined as a period from the rising of a pulse train to the next rising of the pulse train, or may be designated as a period from the zero cross of the AC voltage to the next zero cross thereof, or from the peak of the AC voltage to the next peak thereof. In this case, the frequency f is calculated by the following equation (2).

$$f = 1/T \ ...(2)$$

In a case where a period acquired at the present time is longer than a period acquired at the preceding time, the period calculating unit 112 does not wait in the period at the preceding time until the next period is updated, and performs predicted frequency calculation for updating a predicted frequency (S203) . That is, after the period has been determined at a time point (C) in Fig. 3, and in a case where the period input is not changed after a time point (D) at which the rising is expected to arrive in the same period, a time period during which the period input is not changed is measured, and at least, an acquired period is determined based on a time point at which a period is predicted to be longer than a period at the measured time point where the period input is not changed. For example, at a time point (E), when a period from the rising of a pulse at the preceding time to the falling of the pulse is set to Tpre and Tover has elapsed after the elapse of Tpre, the period calculating unit 112 calculates the frequency f by the following equation (3) and predicts a pulse train input command of a low frequency before acquiring pulse edges.

$$f = 1/(2 \times (Tpre + Tover)) \quad ...(3)$$

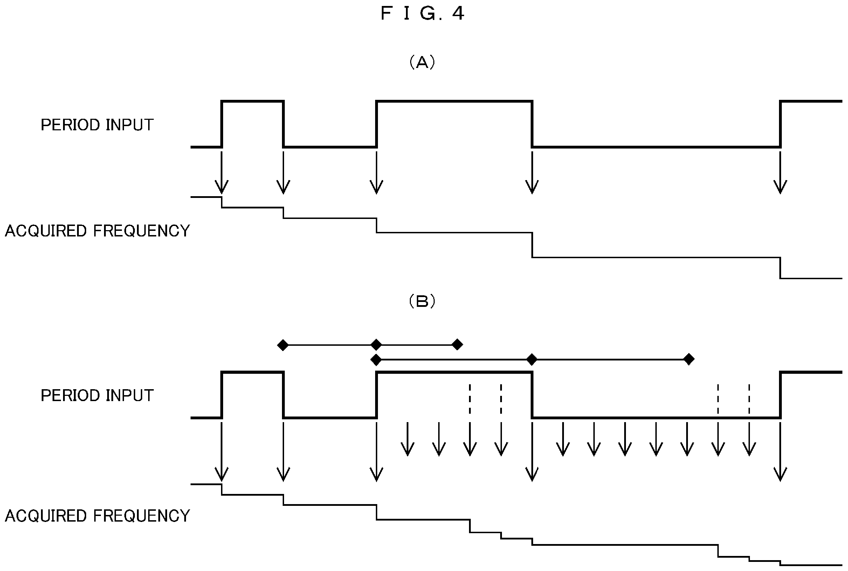

Fig. 4 is a diagram for describing the processing of predicting the acquired frequency before acquiring the pulse edges thereof, in the case of a pulse train input of a low frequency in the present embodiment. Fig. 4(A) is an example of a period input and an acquired frequency in a case where the acquired frequency is calculated for each of a rising edge or falling edge of a pulse, and in the case of a pulse train of a low frequency, a time period in which an edge of the pulse train arrives is longer, so that a timing of updating the acquired frequency also becomes late. On the contrary, Fig. 4(B) is an example of a period input and an acquired frequency in the case of performing prediction processing before acquiring the pulse edges, in which, in a case where a period acquired at the present time is longer than a period acquired at the preceding time, that is, in a case where the next edge does not arrive at a timing when the edge is expected to arrive, it is determined that a speed of the pulse train is low, and at that time, the predicted frequency is calculated to update the acquired frequency. In other words, in a case where the current period input is longer than the next previous period input, the acquired frequency is updated such that the acquired frequency decreases before an edge of the current period input arrives. Therefore, it is possible to make the timing of updating the acquired frequency early. That is, it is possible to make the timing of updating update information early.

Also, as illustrated in a timing (F) in Fig. 3, when an external command becomes zero, there is no period input. Therefore, in a case where the predicted, calculated, and acquired frequency falls below a frequency previously set as the minimum command value, it is possible to cut off an output in the same manner as a state in which there is no period input.

Then, in Fig. 2, the period calculating unit 112 outputs a calculation result as a final acquired frequency (S204).

As described above, when a normal pulse is recognized as the command frequency, an interval between time points at which the pulse edges arrive becomes longer as the frequency of the pulse becomes lower. Once a pulse interval becomes longer, a time period up to recognition becomes longer and the responsiveness decreases, and once the command is held, reaction is slow enough to issue a command of a low speed. Therefore, in a case where, when a width of the pulse becomes longer, no pulse arrives during an interval longer than an expected interval in which the same pulse is expected to arrive, a command is predicted to be a command of a low speed. In this way, in a case where the pulse period suddenly becomes longer, it is possible to make the reaction of the pulse acquisition rapid. That is, it is possible to detect a decrease in the command frequency before the period signal arrives.

As described above, the present embodiment is a power conversion device having an AC converting unit that performs power conversion and a calculating unit that controls the AC converting unit, in which the calculating unit includes a period converting unit that converts an input signal into a period signal, a period calculating unit that calculates an acquired frequency from the period signal, and a control unit that outputs an output command according to the acquired frequency, and in a case where the period signal is not acquirable during a period longer than the period of the period signal acquired from the period converting unit at a preceding time, the period calculating unit is configured to calculate a time period during which the period signal is not acquirable, and to output the time period as the acquired frequency.

Also, in the power conversion device having an AC converting unit that performs power conversion and a calculating unit that controls the AC converting unit, the calculating unit includes a period converting unit that converts an input signal into a period signal, a period calculating unit that calculates an acquired frequency from the period signal, and a control unit that outputs a PWM output command according to the acquired frequency, and in a case where a periodic interval of the period signal acquired from the period converting unit is longer than a periodic interval at the preceding time, the period calculating unit is configured to calculate an acquired frequency by using an acquired period based on a time point at which a periodic interval is longer than the periodic interval at the preceding time and the period input is not changed, and to output the acquired frequency.

In the power conversion device having an AC converting unit that performs power conversion and a calculating unit that outputs a command to control the AC converting unit, the command is configured such that, when a command frequency is generated from the period input and a command operation of decreasing the command frequency is performed, the command frequency decreases before an edge of the period input arrives.

In this way, it is possible to provide a power conversion device capable of capturing update information at a timing earlier than a timing of the period determination even though a captured period becomes long.

Embodiment 2

In the present embodiment, an example of operation in which a power conversion device provided with a current detector captures an output frequency for self-diagnosis and cuts off an output of the motor will be described.

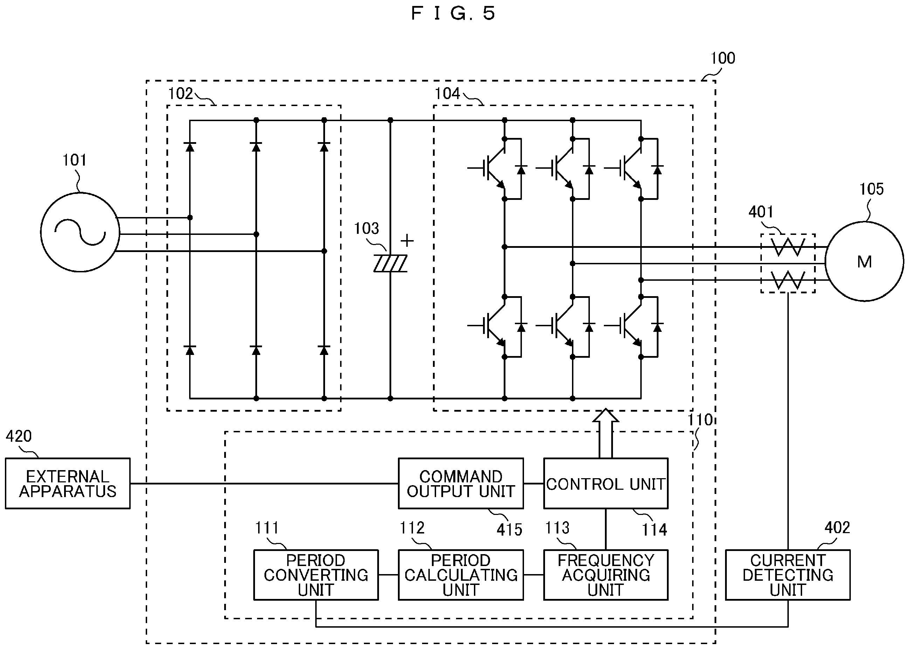

Fig. 5 is an example of a configuration diagram of the power conversion device 100 and the AC motor 105 in the present embodiment. In Fig. 5, components having the same functions as those of Fig. 1 are denoted by the same reference numerals, and the descriptions thereof will not be repeated. In Fig. 5, a current detector 401 is configured with a hole CT or a shunt resistor, and detects a current flowing through the AC converting unit. The current detector 401 may be disposed in any portion of the power conversion device as long as it detects the current of the AC converting unit 104. The current detector 401 acquires at least a current of one phase and outputs the current to a current detecting unit 402.

By using the output of the current detector 401 as an input, for example, the current detecting unit 402 pulse-converts the input based on the zero cross of the AC current as a reference and outputs a pulse to the period converting unit 111.

An external apparatus 420 is for periodically issuing a command to the power conversion device 100, and a signal of the external apparatus is input to a command output unit 415. The command output unit 415 converts the input signal from the external apparatus 420 into an output command frequency and inputs the output command frequency to the control unit 114.

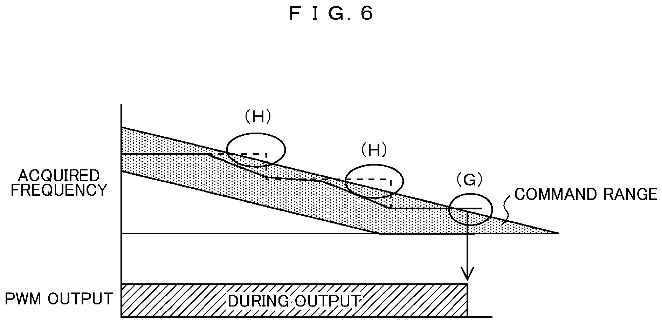

Fig. 6 illustrates a scene in which the PWM output is cut off in a case where the period converting unit 111 acquires a frequency by using the period of the AC current as an input, similarly to Embodiment 1 and in a case where an acquired frequency detected in response to a command output by the control unit 114 is abnormal. In Fig. 6, in a case where the predicted frequency calculation in Embodiment 1 is not performed, the acquired frequency is indicated by a broken line and in a case where the predicted frequency calculation is performed, the acquired frequency is indicated by a solid line. As illustrated in Fig. 6, in a case where the control unit 114 performs a command operation of decreasing the frequency in advance, and in a case where the detected acquired frequency (the solid line) deviates from a command range indicated by hatching (at a time point (G) indicated by a circle), the PWM output is cut off. This is effective in terms of functional safety in a case where stopping is performed after a speed is reduced to a certain extent, that is, a speed is reduced to a frequency originally intended to be decreased and stopping is possible. In a case where the predicted frequency calculation is not performed, the detected acquired frequency (the broken line) immediately deviates from the command range due to the delay in updating (a portion (H) indicated by a circle). However, in a case where the predicted frequency calculation is performed according to the present embodiment, it is possible to update the acquired frequency quickly (the solid line) so that the command range is narrowed and self-diagnosis is performed with high accuracy.

Incidentally, the present invention is not limited to the embodiments described above, but includes various modified examples. For example, the embodiments described above have been described in detail in order to explain the present invention in an easy-to-understand manner, and are not necessarily limited to those having all the configurations described. Also, a part of the configuration of one embodiment can be replaced by the configuration of another embodiment, and the configuration of another embodiment can be added to the configuration of one embodiment. Also, it is possible to add, delete and replace other configurations with respect to the part of the configuration of each embodiment.

Also, a part or all of each of the above-described configurations, functions, processing units, processing means, and the like may be implemented through hardware by designing them, for example, on an integrated circuit. Also, each of the above-described configurations, functions, and the like may be implemented through software by interpreting and executing programs for implementing respective functions by means of a processor. Information such as programs, tables, or files for implementing respective functions can be stored in a memory, a recording apparatus such as a hard disk and a Solid State Drive (SSD), or a recording medium such as an IC card, an SD card, and a DVD.

Also, there are illustrated only control lines and information lines which are deemed to be necessary for description, and it is not necessarily a case where all the control lines and information lines of products are illustrated. In reality, it may be considered that almost all configurations are mutually connected.

REFERENCE SIGNS LIST

| 100 | Power conversion device |
| --- | --- |
| 101 | Three-phase AC power supply |
| 102 | DC converting unit |
| 103 | Smoothing capacitor |
| 104 | AC converting unit |
| 105 | AC motor |
| 110 | Calculating unit |
| 111 | Period converting unit |
| 112 | Period calculating unit |
| 113 | Frequency acquiring unit |
| 114 | Control unit |
| 120, 420 | External apparatus |
| 401 | Current detector |
| 402 | Current detecting unit |
| 415 | Command output unit |

**Claims**

1. A power conversion device comprising:

   an AC converting unit (104) configured to perform power conversion; and
   a calculating unit (110) configured to control the AC converting unit (104),
   wherein the calculating unit (110) includes

   a period converting unit (111) configured to convert an input signal into a period signal,
   a period calculating unit (112) configured to calculate an acquired frequency f from the period signal, and
   a control unit (114) configured to output an output command according to the acquired frequency f, and
   in a case where the period signal is not acquirable during a period longer than a period of the period signal acquired from the period converting unit (111) at a preceding time, the period calculating unit (112) is configured to calculate a time period during which the period signal is not acquirable, and output the time period as the acquired frequency,
   **characterized in that**
   at a time point (E), when a period from the rising of a pulse at the preceding time to the falling of the pulse is set to Tpre and a predetermined time Tover has elapsed after the elapse of Tpre, the period calculating unit (112) is configured to calculate the frequency f by the following equation and predict a pulse train input command of a low frequency before acquiring pulse edges:

$$f = 1/(2 \times (Tpre + Tover)), \P$$

   wherein in a case where a current period input is longer than its previous period input, the acquired frequency is updated such that the acquired frequency decreases before an edge of the current period input arrives, so that it is possible to make a timing of updating the acquired frequency early.

2. The power conversion device according to claim 1, **characterized in that**
   the input signal is a pulse input or an AC signal.

3. The power conversion device according to claim 1, **characterized in** comprising:

   a current detector (401) configured to detect a current flowing through the AC converting unit (104);
   a current detecting unit (402) configured to pulse-convert and detect a current acquired by the current detector (401) and input a pulse to the period converting unit (111); and
   a command output unit (415) configured to convert the input signal into an output command frequency and input the output command frequency to the control unit (114),
   wherein the control unit (114) is configured to cut off an output in a case where the acquired frequency deviates from the range of the output command.

4. The power conversion device according to claim 1, **characterized in that**
the control unit (114) is configured to cut off an output in a case where the acquired frequency falls below a predetermined value.

5. A power conversion device according to claim 1, **characterized in that**
in a case where a periodic interval of the period signal acquired from the period converting unit (111) is longer than a periodic interval at the preceding time, the period calculating unit (112) is configured to calculate the acquired frequency by using an acquired period based on a time point at which a periodic interval is longer than the periodic interval at the preceding time and the period input is not changed, and output the acquired frequency.

6. A power conversion device according to claim 1 **characterized by**:
the calculating unit (110) configured to output a command to control the AC converting unit (104),
wherein the command is configured such that, when a command frequency is generated from the period input and the current period input is longer than its previous period input, the command frequency decreases before an edge of the current period input arrives, and the acquired frequency is updated quickly, so that a command range is narrowed and self-diagnosis of the power conversion device can be performed with high accuracy.

**Patentansprüche**

1. Leistungsumsetzungsvorrichtung, die Folgendes umfasst:

eine Wechselstrom-Umsetzungseinheit (104), die konfiguriert ist, eine Leistungsumsetzung durchzuführen; und
eine Berechnungseinheit (110), die konfiguriert ist, die Wechselstrom-Umsetzungseinheit (104) zu steuern,
wobei die Berechnungseinheit (110) Folgendes enthält:

eine Periodenumsetzungseinheit (111), die konfiguriert ist, ein Eingangssignal in ein Periodensignal umzusetzen,
eine Periodenberechnungseinheit (112), die konfiguriert ist, eine erfasste Frequenz f aus dem Periodensignal zu berechnen, und
eine Steuereinheit (114), die konfiguriert ist, einen Ausgangsbefehl gemäß der erfassten Frequenz f auszugeben, und

dann, wenn das Periodensignal während eines Zeitraums, der länger als eine Periode des Periodensignals ist, das zu einer vorhergehenden Zeit von der Periodenumsetzungseinheit (111) erfasst worden ist, nicht erfassbar ist, die Periodenberechnungseinheit (112) konfiguriert ist, einen Zeitraum zu berechnen, währenddessen das Periodensignal nicht erfassbar ist, und den Zeitraum als die erfasste Frequenz auszugeben,
**dadurch gekennzeichnet, dass**
zu einem Zeitpunkt (E), zu dem eine Periode vom Ansteigen eines Pulses zu der vorhergehenden Zeit bis zum Abfallen des Pulses auf Tpre eingestellt ist und eine vorgegebene Zeit Tover nach dem Verstreichen von Tpre verstrichen ist, die Periodenberechnungseinheit (112) konfiguriert ist, die Frequenz f durch die folgende Gleichung zu berechnen und einen Pulsfolgen-Eingangsbefehl mit einer niedrigen Frequenz, bevor Pulsflanken erfasst werden, vorherzusagen:

$$f = 1 /(2 \times (\text{Tpre} + \text{Tover})),$$

wobei dann, wenn ein aktueller Periodeneingang länger als sein vorhergehender Periodeneingang ist, die erfasste Frequenz derart aktualisiert wird, dass die erfasste Frequenz abnimmt, bevor eine Flanke des aktuellen Periodeneingangs eintrifft,
derart, dass es möglich ist, frühzeitig eine Zeitvorgabe der Aktualisierung der erfassten Frequenz vorzunehmen.

2. Leistungsumsetzungsvorrichtung nach Anspruch 1,
**dadurch gekennzeichnet, dass**
das Eingangssignal ein Pulseingang oder ein Wechselstromsignal ist.

3. Leistungsumsetzungsvorrichtung nach Anspruch 1,
**dadurch gekennzeichnet, dass** sie Folgendes umfasst:

einen Stromdetektor (401), der konfiguriert ist, einen Strom zu detektieren, der durch die Wechselstrom-Umsetzungseinheit (104) fließt;

eine Stromdetektionseinheit (402), die konfiguriert ist, einen Strom, der durch den Stromdetektor (401) erfasst wird, in Pulse umzusetzen und zu detektieren und einen Puls in die Pulsumsetzungseinheit (111) einzugeben; und

eine Befehlsausgabeeinheit (415), die konfiguriert ist, das Eingangssignal in eine Ausgangsbefehlsfrequenz umzusetzen und die Ausgangsbefehlsfrequenz in die Steuereinheit (114) einzugeben,

wobei die Steuereinheit (114) konfiguriert ist, einen Ausgang auszuschalten, wenn die erfasste Frequenz von dem Bereich des Ausgangsbefehls abweicht.

4. Leistungsumsetzungsvorrichtung nach Anspruch 1,
**dadurch gekennzeichnet, dass**
die Steuereinheit (114) konfiguriert ist, einen Ausgang auszuschalten, wenn die erfasste Frequenz unter einen vorgegebenen Wert abfällt.

5. Leistungsumsetzungsvorrichtung nach Anspruch 1,
**dadurch gekennzeichnet, dass**
dann, wenn ein periodisches Intervall des Periodensignals, das von der Periodenumsetzungseinheit (111) erfasst wird, länger als ein periodisches Intervall zu der vorhergehenden Zeit ist, die Periodenberechnungseinheit (112) konfiguriert ist, die erfasste Frequenz unter Verwendung einer erfassten Periode auf der Grundlage eines Zeitpunkts, zu dem ein periodisches Intervall länger als das periodische Intervall zu der vorhergehenden Zeit ist und der Periodeneingang nicht verändert wird, zu berechnen und die erfasste Frequenz auszugeben.

6. Leistungsumsetzungsvorrichtung nach Anspruch 1,
**dadurch gekennzeichnet, dass**
die Berechnungseinheit (110) konfiguriert ist, einen Befehl auszugeben, um die Wechselstrom-Umsetzungseinheit (104) zu steuern,

wobei der Befehl derart konfiguriert ist, dass dann, wenn eine Befehlsfrequenz aus dem Periodeneingang erzeugt wird und der aktuelle Periodeneingang länger als sein vorhergehender Periodeneingang ist, die Befehlsfrequenz abnimmt, bevor eine Flanke des aktuellen Periodeneingangs eintrifft, und die erfasste Frequenz schnell aktualisiert wird, derart, dass ein Befehlsbereich eingeengt wird und eine Selbstdiagnose der Leistungsumsetzungsvorrichtung mit hoher Genauigkeit durchgeführt werden kann.

## Revendications

1. Dispositif de conversion de puissance comprenant :

une unité de conversion CA (courant alternatif) (104) configurée pour effectuer une conversion de puissance ; et
une unité de calcul (110) configurée pour commander l'unité de conversion CA (104),
dans lequel l'unité de calcul (110) inclut
une unité de conversion périodique (111) configurée pour convertir un signal d'entrée en signal périodique,
une unité de calcul périodique (112) configurée pour calculer une fréquence f acquise à partir du signal périodique, et
une unité de commande (114) configurée pour sortir un ordre de sortie en accord avec la fréquence f acquise, et
dans un cas où le signal périodique ne peut pas être acquis pendant une période plus longue qu'une période du signal périodique acquis depuis l'unité de conversion périodique (111) à un instant précédent, l'unité de calcul périodique (112) est configurée pour calculer une période temporelle pendant laquelle le signal périodique ne peut pas être acquis, et pour sortir la période temporelle à titre de fréquence acquise,
**caractérisé en ce que**
à un instant temporel (E) auquel une période depuis l'élévation d'une impulsion à l'instant précédent jusqu'à la chute de l'impulsion est fixée à Tpre et un instant prédéterminé Tover s'est écoulé après écoulement de Tpre, l'unité de calcul périodique (112) est configurée pour calculer la fréquence f au moyen de l'équation suivante, et pour prédire un ordre d'entrée de train d'impulsions d'une fréquence basse avant acquisition des fronts d'impulsion :

$$f = 1 / (2 \times (Tpre + Tover)),$$

dans lequel, dans un cas où une entrée périodique actuelle est plus longue que son entrée périodique antérieure, la fréquence acquise est mise à jour de sorte que la fréquence acquise diminue avant qu'un front de l'entrée périodique actuelle arrive,

de sorte qu'il est possible de faire une temporisation de mise à jour de la fréquence acquise plus tôt.

**2.** Dispositif de conversion de puissance selon la revendication 1, **caractérisé en ce que**
le signal d'entrée est une entrée d'impulsion ou un signal CA.

**3.** Dispositif de conversion de puissance selon la revendication 1, **caractérisé en ce qu'**il comprend :

un détecteur de courant (401) configuré pour détecter un courant s'écoulant à travers l'unité de conversion CA (104) ;

une unité de détection de courant (402) configurée pour convertir en impulsion et détecter un courant acquis par le détecteur de courant (401), et pour entrer une impulsion vers l'unité de conversion périodique (111) ; et

une unité de sortie d'ordre (415) configurée pour convertir le signal d'entrée en une fréquence d'ordre de sortie et pour entrer la fréquence d'ordre de sortie vers l'unité de commande (114),

dans lequel l'unité de commande (114) est configurée pour couper une sortie dans un cas où la fréquence acquise s'écarte de la plage d'ordre de sortie.

**4.** Dispositif de conversion de puissance selon la revendication 1, **caractérisé en ce que**
l'unité de commande (114) est configurée pour couper une sortie dans un cas où la fréquence acquise chute en dessous d'une valeur prédéterminée.

**5.** Dispositif de conversion de puissance selon la revendication 1, **caractérisé en ce que**
dans un cas où un intervalle périodique du signal périodique acquis depuis l'unité de conversion périodique (111) est plus long qu'un intervalle périodique à l'instant précédent, l'unité de calcul périodique (112) est configurée pour calculer la fréquence acquise en utilisant une période acquise sur la base d'un point temporel auquel un intervalle périodique est plus long que l'intervalle périodique à l'instant précédent et l'entrée périodique n'est pas changée, et pour sortir la fréquence acquise.

**6.** Dispositif de conversion de puissance selon la revendication 1, **caractérisé en ce que** :

l'unité de calcul (110) est configurée pour sortir un ordre pour commander l'unité de conversion CA (104),

dans lequel l'ordre est configuré de sorte que, quand une fréquence d'ordre est générée à partir de l'entrée périodique et que l'entrée périodique actuelle est plus longue que son entrée périodique antérieure, la fréquence d'ordre diminue avant qu'un front de l'entrée périodique actuelle arrive, et la fréquence acquise est mise à jour rapidement, de sorte qu'une plage d'ordre est rétrécie et qu'un autodiagnostic du dispositif de conversion de puissance peut être effectué avec une haute précision.

EP 3 506 483 B1

FIG. 2

```
                          ╭───────────╮
                          │   Start   │
                          ╰───────────╯
                                │
      S201                      ▼
     ┌────────────────────────────────────────┐
     │       ACQUIRE FREQUENCY AT              │
     │         PRECEDING TIME                  │
     └────────────────────────────────────────┘
                                │
      S202                      ▼
   No        ◇─────────────────────────────────────────◇
  ◄──────────  IS PERIODIC INTERVAL LONGER THAN THAT AT
             ◇         PRECEDING TIME?                  ◇
   │           ◇─────────────────────────────────────◇
   │                            │ Yes
   │  S213                      │  S203
   ▼                            ▼
┌──────────────────┐    ┌──────────────────┐
│ CALCULATE ACQUIRED│    │ CALCULATE PREDICTED│
│    FREQUENCY      │    │    FREQUENCY      │
└──────────────────┘    └──────────────────┘
   │                            │
   └────────────────────────►───○
                                │
      S204                      ▼
     ┌────────────────────────────────────────┐
     │        OUTPUT ACQUIRED                  │
     │          FREQUENCY                      │
     └────────────────────────────────────────┘
                                │
                                ▼
                          ╭───────────╮
                          │    End    │
                          ╰───────────╯
```

F I G . 3

(A)

PERIOD INPUT

ACQUIRED FREQUENCY

(B)

PERIOD INPUT

ACQUIRED FREQUENCY

EP 3 506 483 B1

F I G . 5

EP 3 506 483 B1

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011101445 A
- EP 0802622 A2
- JP 2014212631 A
- US 2011218751 A1
- US 2013054666 A1